# EUROPÄISCHE PATENTSCHRIFT

(11) **EP 3 077 478 B1**
(45) Veröffentlichungstag und Bekanntmachung des Hinweises auf die Patenterteilung: **05.05.2021**
(21) Anmeldenummer: 14799173.1
(22) Anmeldetag: 18.11.2014
(51) Int. Cl.: C09K 11/80, C09K 11/59

(54) **LEUCHTSTOFFMISCHUNG, LICHT EMITTIERENDES HALBLEITERBAUELEMENT MIT EINER LEUCHTSTOFFMISCHUNG UND STRASSENLATERNE MIT EINER LEUCHTSTOFFMISCHUNG**
LUMINESCENT-SUBSTANCE MIXTURE, LIGHT-EMITTING SEMICONDUCTOR COMPONENT HAVING A LUMINESCENT-SUBSTANCE MIXTURE, AND STREETLAMP HAVING A LUMINESCENT-SUBSTANCE MIXTURE
MÉLANGE DE SUBSTANCES LUMINESCENTES, COMPOSANT À SEMI-CONDUCTEUR ÉLECTROLUMINESCENT COMPRENANT UN MÉLANGE DE SUBSTANCES LUMINESCENTES ET RÉVERBÈRE COMPRENANT UN MÉLANGE DE SUBSTANCES LUMINESCENTES

(30) Priorität: 03.12.2013 DE 102013113382
(43) Veröffentlichungstag der Anmeldung: 12.10.2016
(73) Patentinhaber: OSRAM Opto Semiconductors GmbH, 93055 Regensburg (DE)
(72) Erfinder: RÖMER, Rebecca, 86150 Augsburg (DE); HUCKENBECK, Barbara, 86159 Augsburg (DE); LANGE, Stefan, 86157 Augsburg (DE); CUI, Hailing, 93051 Regensburg (DE)
(74) Vertreter: Epping - Hermann - Fischer
(86) Internationale Anmeldenummer: PCT/EP2014/074911
(87) Internationale Veröffentlichungsnummer: WO 2015/082209

(56) Entgegenhaltungen:
- EP-A1- 2 432 037
- WO-A1-2008/065567
- WO-A1-2011/022399
- DE-A1-102009 037 732
- DE-A1-102012 101 920
- US-A1- 2011 220 929
- US-A1- 2012 075 549

## Beschreibung

Diese Patentanmeldung beansprucht die Priorität der deutschen Patentanmeldung 10 2013 113 382.7, deren Offenbarungsgehalt hiermit durch Rückbezug aufgenommen wird.

Die Druckschrift DE 10 2012 101920 A1 offenbart ein optoelektronisches Bauelement mit einem Konversionsmaterial, das einen ersten Leuchtstoff und einen zweiten Leuchtstoff umfasst.

Die Druckschrift WO 2011/022399 A1 offenbart eine Leuchtstoffmischung für eine LED-Lichtquelle.

Die Druckschrift US 2012/0075549 A1 offenbart eine weißlichtemittierende Diode mit einem grünen Leuchtstoffmaterial und einem orangefarbenen Leuchtstoffmaterial.

Die Druckschrift WO 2008/065567 A1 offenbart ein Beleuchtungssystem mit einem lumineszierenden Material, das zumindest einen ersten Leuchtstoff umfasst.

Die Druckschrift EP 2432037 A1 offenbart ein weißlichtemittierendes Halbleiterbauelement.

Die Druckschrift US 2011/0220929 A1 offenbart warmweiße LEDs mit einem luminophoren Medium.

Die Druckschrift DE 10 2009 037732 A1 offenbart eine Konversion-LED mit einer Leuchtstoffmischung.

Es werden eine Leuchtstoffmischung, ein Licht emittierendes Halbleiterbauelement mit einer Leuchtstoffmischung und eine Straßenlaterne mit einer Leuchtstoffmischung angegeben.

Weißlicht emittierende Dioden haben eine wesentliche Bedeutung für die Allgemeinbeleuchtung. Für Anwendungen in der Außenbeleuchtung, beispielsweise zur Beleuchtung von Straßen, wird häufig ein Farbwiedergabeindex von mindestens 70 gefordert. Um eine große Vielfalt an Verkehrs- und Straßensituationen adäquat beleuchten zu können ist zudem eine große Flexibilität bezüglich der realisierbaren Farbtemperatur, beispielsweise in einem Bereich von 3000 K bis 6500 K wünschenswert. Da die Umgebungsbedingungen bei der Straßenbeleuchtung, etwa die Umgebungstemperatur, stark schwanken können, ist zudem eine hohe Stabilität des Farborts und der Helligkeit bei wechselnden Temperaturen von großem Vorteil. Weiterhin muss eine Licht emittierende Diode zum Einsatz in der Straßenbeleuchtung eine sehr hohe Alterungsstabilität, insbesondere gegen Umwelteinflüsse wie Feuchtigkeit, aufweisen. Gleichzeitig soll die Systemeffizienz aus Gründen der Energieeinsparung und der Minimierung der Kosten möglichst hoch sein.

Zumindest eine Aufgabe von bestimmten Ausführungsformen ist es, eine Leuchtstoffmischung anzugeben, die dazu geeignet ist, Licht mit einem möglichst hohen Farbwiedergabeindex über einen möglichst großen Temperaturbereich zu erzeugen. Aufgaben von weiteren Ausführungsformen sind es, ein Licht emittierendes Halbleiterbauelement sowie eine Straßenlaterne mit einer solchen Leuchtstoffmischung anzugeben.

Diese Aufgaben werden durch Gegenstände gemäß den unabhängigen Patentansprüchen gelöst. Vorteilhafte Ausführungsformen und Weiterbildungen der Gegenstände sind in den abhängigen Ansprüchen gekennzeichnet und gehen weiterhin aus der nachfolgenden Beschreibung und den Zeichnungen hervor.

Erfindungsgemäß weist eine Leuchtstoffmischung einen ersten Leuchtstoff und einen zweiten Leuchtstoff auf. Der erste Leuchtstoff weist ein Emissionsspektrum mit einem relativen Intensitätsmaximum im gelblich-grünen Spektralbereich auf. Der zweite Leuchtstoff weist ein Emissionsspektrum mit einem relativen Intensitätsmaximum im orange-roten Spektralbereich auf. Der erste Leuchtstoff weist ein relatives Intensitätsmaximum bei einer Wellenlänge von größer oder gleich 540 nm und kleiner oder gleich 560 nm und der zweite Leuchtstoff ein relatives Intensitätsmaximum bei einer Wellenlänge von größer oder gleich 600 nm und kleiner oder gleich 620 nm auf. Die Leuchtstoffe weisen die Emissionsspektren mit den angegebenen relativen Intensitätsmaxima bei Anregung mit blauem Licht auf.

Insbesondere kann die Leuchtstoffmischung dazu vorgesehen und geeignet sein, bei Anregung mit Licht aus dem blauen Spektralbereich Licht mit einem Farbort der CIE-Normfarbtafel in einem weißen Bereich zu erzeugen. Hierzu wandelt der erste Leuchtstoff bevorzugt einen Teil von eingestrahltem Licht in einem ersten Wellenlängenbereich, insbesondere blauem Licht, in Licht in einem zweiten Wellenlängenbereich, insbesondere in gelblich-grünes Licht, um, während der zweite Leuchtstoff einen weiteren Teil des eingestrahlten Lichts im ersten Wellenlängenbereich in Licht in einem dritten Wellenlängenbereich, insbesondere in orange-rotes Licht, umwandelt. Besonders bevorzugt bleibt ein Teil des eingestrahlten Lichts im ersten Wellenlängenbereich unkonvertiert, so dass Mischlicht entsteht, das sich vorzugsweise aus blauem unkonvertierten Licht des ersten Wellenlängenbereichs sowie gelblich-grünes durch den ersten Leuchtstoff konvertiertes Licht des zweiten Wellenlängenbereichs und orange-rotem konvertiertem Licht des dritten Wellenlängenbereichs zusammensetzt.

Erfindungsgemäß weist das von der Leuchtstoffmischung bei Anregung mit blauem Licht erzeugte Licht einen Farbort mit einer Farbtemperatur zwischen einschließlich 3000 K und einschließlich 6500 K auf. Der Begriff "Farbtemperatur" kann hier und im Folgenden die Farbtemperatur eines planckschen Schwarzkörperstrahlers bezeichnen oder auch die dem Fachmann bekannte so genannte korrelierte Farbtemperatur ("correlated color temperature", CCT) im Falle eines weißen Leuchteindrucks, der durch Farbortkoordinaten charakterisiert wird, die von den Farbortkoordinaten der planckschen Schwarzkörperstrahler abweichen. Der Farbwiedergabeindex des von der Leuchtstoffmischung bei Anregung mit blauem Licht erzeugten Lichtes beträgt mindestens 65 und bevorzugt mindestens 70. Besonders bevorzugt ist die Leuchtstoffmischung dazu geeignet, stabil gegenüber Betriebstemperaturen von größer oder gleich 85°C zu sein.

Gemäß einer weiteren Ausführungsform ist der erste Leuchtstoff ein Granatleuchtstoff. Insbesondere kann der erste Leuchtstoff aus dem Materialsystem (Y, Lu, Gd, Ce)₃(Al, Ga)₅O₁₂ ausgewählt sein. Als alternative Bezeichnung für hier und im Folgenden beschriebene Granatleuchtstoffe, die Ce enthalten, kann auch die Schreibweise "...:Ce" verwendet werden, also beispielsweise (Y, Lu, Gd)₃(Al, Ga)₅O₁₂:Ce.

Die hier und im Folgenden für den ersten und zweiten Leuchtstoff angegebenen Materialsysteme sind in Bezug auf die Summenformeln nicht streng mathematisch zu verstehen. Vielmehr können der erste und zweite Leuchtstoff immer noch unter die angegebenen Summenformeln gefasst werden, wenn zu einem geringen Grad zusätzlich Materialien, beispielsweise Verunreinigungen, enthalten sind. Im Fall von Granatleuchtstoffen kann beispielsweise der Sauerstoff zu einem geringen Teil durch Materialien wie etwa N, F, Cl, Br ersetzt sein.

### Erfindungsgemäß ist der erste Leuchtstoff ausgewählt aus dem Materialsystem

(Y, Lu, Ce)₃Al₅O₁₂ mit einem Ce-Gehalt von größer oder gleich 0,5% und kleiner oder gleich 5% und einem Y-Gehalt von größer oder gleich 0% und kleiner oder gleich 20%. Besonders bevorzugt kann der Ce-Gehalt größer oder gleich 1% und kleiner oder gleich 3% sein. Der Y-Gehalt kann besonders bevorzugt größer oder gleich 5% und kleiner oder gleich 20% sein. Soweit nicht anders angegeben, werden hier und im Folgenden mit Prozentangaben im Zusammenhang mit Leuchtstoffzusammensetzungen Mol-% bezeichnet. Weiterhin kann auch ein Teil des Al durch Ga substituiert sein. Besonders bevorzugt weist der erste Leuchtstoff mit der angegebenen Zusammensetzung einen Emissionsbereich mit einem Intensitätsmaximum im Bereich von größer oder gleich 540 nm und kleiner oder gleich 560 nm auf.

Gemäß einer weiteren Ausführungsform ist der zweite Leuchtstoff ein Nitridosilikat-Leuchtstoff. Erfindungsgemäß ist der zweite Leuchtstoff ausgewählt aus den Materialsystemen (Ca, Sr, Ba, Eu)2Si₅N₈ und (Ca, Sr, Eu)AlSiN₃•Si₂N₂O. Als alternative Bezeichnung für hier und im Folgenden beschriebene Nitridosilikat-Leuchtstoffe, die Eu enthalten, kann auch die Schreibweise "...:Eu" verwendet werden, also beispielsweise (Ca, Sr, Ba)₂Si₅N₈:Eu. Weiterhin kann der zweite Leuchtstoff aus einem Materialsystem ausgewählt sein, das in der Patentanmeldung DE 10 2013 222 144.4 beschrieben ist, deren Offenbarungsgehalt hiermit diesbezüglich vollumfänglich durch Rückbezug aufgenommen wird. Der zweite Leuchtstoff weist besonders bevorzugt eine Peakwellenlänge der Emission, also ein relatives Intensitätsmaximum, bei einer Wellenlänge im Bereich von größer oder gleich 600 nm und kleiner oder gleich 620 nm und besonders bevorzugt im Bereich von größer oder gleich 605 nm und kleiner oder gleich 615 nm auf. Wie bereits oben beschrieben kann der zweite Leuchtstoff wie auch der erste Leuchtstoff auch dann noch unter die angegebenen Materialsysteme fallen, wenn er zu einem geringen Grad zusätzliche Materialien wie etwa Verunreinigungen aufweist. Solche zusätzlichen Materialien können beispielsweise F, Cl, Br, C, O, B, Al sein.

Es wird auch beschrieben, dass der zweite Leuchtstoff aus den Materialsystem (Ca, Sr, Eu)AlSiN₃ ausgewählt sein kann.

Erfindungsgemäß ist der zweite Leuchtstoff ausgewählt aus dem Materialsystem
(Ca, Sr, Ba, Eu)2Si₅N₈ mit einem Eu-Gehalt von größer oder gleich 1% und kleiner oder gleich 2,5%, mit einem Ba-Gehalt von größer oder gleich 45% und kleiner oder gleich 55% und mit einem Ca-Gehalt von größer oder gleich 0% und kleiner oder gleich 10%. Hierbei ist der Sr-Gehalt so gewählt, dass die Summe der Erdalkalimetalle und Europium, also die Summe der Eu-, Ba-, Ca- und Sr-Gehalte, 100% ergibt. Ein solcher zweiter Leuchtstoff kann sich neben einer hohen Konversionseffizienz, Temperaturstabilität der Emission und chemischen Beständigkeit auch durch eine sehr hohe Stabilität gegenüber Strahlung, hohen Temperaturen, Feuchtigkeit und Kombinationen daraus auszeichnen.

Es wird auch beschrieben, dass der zweite Leuchtstoff ausgewählt ist aus dem Materialsystem
(Ca, Sr, Ba, Eu)₂Si₅N₈ mit einem Eu-Gehalt von größer oder gleich 0,5% und kleiner oder gleich 4%, mit einem Ba-Gehalt von größer oder gleich 30% und kleiner oder gleich 70% und mit einem Ca-Gehalt von größer oder gleich 0% und kleiner oder gleich 20%.

Gemäß einer weiteren Ausführungsform ist der zweite Leuchtstoff ausgewählt aus dem Materialsystem
(Ca, Sr, Eu)AlSiN₃•Si₂N₂O mit einem Eu-Gehalt von größer oder gleich 0,1% und kleiner oder gleich 2% und mit einem Sr-Gehalt von größer oder gleich 60% und kleiner oder gleich 100%. Hierbei ist der Ca-Gehalt so gewählt, dass die Summe der Eu-, Sr- und Ca-Gehalte 100% ergibt. Bevorzugt ist der zweite Leuchtstoff so gewählt, dass der Eu-Gehalt größer oder gleich 0,3% und kleiner oder gleich 1% und/oder der Sr-Gehalt größer oder gleich 80% und kleiner oder gleich 100% sind.

Besonders bevorzugt weist das Anregungsspektrum des ersten und/oder des zweiten Leuchtstoffs im blauen Spektralbereich bei einer Wellenlänge von größer oder gleich 440 nm und kleiner oder gleich 460 nm und bevorzugt von größer oder gleich 445 nm und kleiner oder gleich 455 nm ein relatives Maximum auf.

Die Leuchtstoffmischung kann beispielsweise aus Leuchtstoffpartikeln gebildet sein. Das bedeutet, dass der erste Leuchtstoff und/oder der zweite Leuchtstoff in Form von Partikeln in der Leuchtstoffmischung vorliegen, wobei eine Vielzahl an ersten Partikeln den ersten Leuchtstoff aufweist oder aus dem ersten Leuchtstoff gebildet ist und eine Vielzahl an zweiten Partikeln den zweiten Leuchtstoff aufweist oder aus dem zweiten Leuchtstoff gebildet ist.

Die Partikel des ersten Leuchtstoffs und/oder die Partikel des zweiten Leuchtstoffs weisen bevorzugt eine mittlere Korngröße zwischen einschließlich 5 µm und einschließlich 50 µm und besonders bevorzugt zwischen einschließlich 10 µm und einschließlich 30 µm auf.

Die Partikel der Leuchtstoffe können weiterhin eine Beschichtung aufweisen. Insbesondere für einen zweiten Leuchtstoff ausgewählt aus dem Materialsystem (Ca, Sr, Eu)AlSiN₃•Si₂N₂O ist eine Beschichtung mit einem inerten Material, beispielsweise SiO₂ und/oder Al₂O₃, vorteilhaft, um den Leuchtstoff zu stabilisieren, da die Wirtsstruktur eine intrinsische Instabilität gegenüber Feuchtigkeit zeigt, die zu einer raschen Degradation unter Bedingungen mit hoher Luftfeuchtigkeit führen kann.

Weiterhin ist es auch möglich, dass die Leuchtstoffmischung aus verschiedenen Schichten gebildet ist, wobei eine erste Schicht den ersten Leuchtstoff aufweist oder aus dem ersten Leuchtstoff gebildet ist und eine zweite Schicht den zweiten Leuchtstoff aufweist oder aus dem zweiten Leuchtstoff gebildet ist.

Die hier beschriebenen Leuchtstoffe weisen zu den vorab beschriebenen Vorteilen den weiteren Vorteil auf, dass sie ein besonders geringes Quenching-Verhalten bei thermischer Belastung, also eine im Vergleich zu anderen Leuchtstoffen geringere Reduktion der Konversionseffizienz bei hohen Temperaturen, aufweisen. Weiterhin zeigen die hier beschriebenen Leuchtstoffe auch eine hohe Beständigkeit gegenüber Strahlung und Feuchtigkeit.

Besonders bevorzugt ist die Leuchtstoffmischung frei von einem weiteren wellenlängenkonvertierenden Material. Mit anderen Worten erfolgt Wellenlängenkonversion bei der hier vorgeschlagenen Leuchtstoffmischung besonders bevorzugt lediglich durch den ersten Leuchtstoff und durch den zweiten Leuchtstoff. Unter Wellenlängenkonversion wird vorliegend verstanden, dass der Leuchtstoff eingestrahltes Licht eines bestimmten Wellenlängenbereichs absorbiert, diese Strahlung in Strahlung eines anderen Wellenlängenbereichs umwandelt und wieder emittiert. Insbesondere reine Streuung, Absorption oder Reflexion ohne Umwandlung in Strahlung einer anderen Wellenlänge wird vorliegend nicht als Wellenlängenkonversion verstanden.

Gemäß einer Ausführungsform weist der erste Leuchtstoff zu dem zweiten Leuchtstoff, bezogen auf das Gewicht, ein Verhältnis von kleiner oder gleich 100:1 oder 60:1 oder 40:1 und größer oder gleich 2:1 oder 1:1 oder 0,5:1 auf.

Insbesondere ist die Leuchtstoffmischung gemäß den vorab beschriebenen Ausführungsformen dazu geeignet, in Verbindung mit einem Licht emittierenden Halbleiterchip in einem Licht emittierenden Halbleiterbauelement verwendet zu werden. Der Licht emittierende Halbleiterchip sendet im Betrieb besonders bevorzugt Licht in einem ersten Wellenlängenbereich aus und die beschriebene Leuchtstoffmischung wandelt zumindest einen Teil der von dem Licht emittierender Halbleiterchip ausgesandten Strahlung in Licht des zweiten und des dritten Wellenlängenbereichs um, wobei der erste, der zweite und der dritte Wellenlängenbereich voneinander verschieden sind. Dass der erste, zweite und dritte Wellenlängenbereich voneinander verschieden sind, kann insbesondere bedeuten, dass die Wellenlängenbereiche voneinander verschiedene Intensitätsmaxima aufweisen. Darüber hinaus können die verschiedenen Wellenlängenbereiche aber auch teilweise überlappen. Bei dem ersten Wellenlängenbereich handelt es sich bevorzugt um das Emissionsspektrum des Licht emittierenden Halbleiterchips. Bei dem zweiten Wellenlängenbereich handelt es sich bevorzugt um das Emissionsspektrum des ersten Leuchtstoffs. Bei dem dritten Wellenlängenbereich handelt es sich bevorzugt um das Emissionsspektrum des zweiten Leuchtstoffs.

Der Licht emittierende Halbleiterchip ist hierbei dazu vorgesehen, die Leuchtstoffmischung zur Wellenlängenkonversion anzuregen. Der Licht emittierende Halbleiterchip sendet daher besonders bevorzugt von einer Lichtaustrittsfläche Licht im ersten Wellenlängenbereich aus dem blauen Spektralbereich aus. Besonders bevorzugt sendet der Licht emittierende Halbleiterchip Licht aus, das an das Anregungsspektrum des ersten Leuchtstoffs und/oder des zweiten Leuchtstoffs angepasst ist. Besonders bevorzugt weist das Emissionsspektrum des Licht emittierenden Halbleiterchips zumindest ein relatives oder ein absolutes Maximum auf, das von einem relativen oder einem absoluten Maximum des Anregungsspektrums des ersten Leuchtstoffs um nicht mehr als 20 nm und bevorzugt um nicht mehr als 10 nm abweicht.

Gemäß einer weiteren Ausführungsform weist der erste Wellenlängenbereich, also das Emissionsspektrum des Licht emittierenden Halbleiterchips, eine Dominanzwellenlänge von größer oder gleich 440 nm und kleiner oder gleich 460 nm und bevorzugt von größer oder gleich 445 nm und kleiner oder gleich 455 nm auf. Die Dominanzwellenlänge ist hierbei insbesondere nicht mit einer Peak-Wellenlänge gleichzusetzen. Die Dominanzwellenlänge korrespondiert zu dem Wert des Schnittpunkts der Konturlinie des CIE-Diagramms, also der Spektralfarblinie im CIE-Diagramm, mit der Verbindungslinie zwischen dem Farbort des angegebenen Lichts und dem Unbuntpunkt mit den Farbortkoordinaten cx = cy = 1/3.

Insbesondere im Fall, dass die Leuchtstoffmischung wie oben beschrieben Leuchtstoffpartikel aufweist, sind diese gemäß einer Ausführungsform in ein Harz, bevorzugt ein Silikon oder Epoxid, eingebracht. Das Harz mit den Leuchtstoffpartikeln ist beispielsweise in Form einer Wellenlängenkonversionsschicht auf dem Licht emittierender Halbleiterchip angeordnet. Weiterhin ist es auch möglich, dass das Harz mit den Leuchtstoffpartikeln in Form eines Volumenvergusses über dem Licht emittierender Halbleiterchip angeordnet ist. Hierbei ist der Licht emittierende Halbleiterchip bevorzugt in einer Ausnehmung eines Bauelementgehäuses angeordnet, in die der Verguss eingefüllt ist, so dass der Licht emittierende Halbleiterchip von dem Verguss umhüllt ist.

Weiterhin versteht es sich, dass die Leuchtstoffmischung auf jede andere Art und Weise derart innerhalb des Licht emittierenden Halbleiterbauelements angeordnet sein kann, dass ein gewünschter Teil des von dem Licht emittierenden Halbleiterchip ausgesandten primären Lichts im ersten Wellenlängenbereich durch die Leuchtstoffmischung hindurch tritt oder auf die Leuchtstoffmischung auftritt und von dieser konvertiert wird.

Besonders bevorzugt sendet das Licht emittierende Halbleiterbauelement mischfarbiges Licht aus, das sich aus Licht des ersten Wellenlängenbereichs und Licht der zwei weiteren Wellenlängenbereiche zusammensetzt und einen Farbort im weißen Bereich der CIE-Normfarbtafel aufweist. Besonders bevorzugt weist das vom Licht emittierenden Halbleiterbauelement abgestrahlte Licht einen Farbwiedergabeindex von größer oder gleich 65 und besonders bevorzugt von größer oder gleich 70 bei einer Farbtemperatur von größer oder gleich 3000 K und kleiner oder gleich 6500 K auf.

Die vorliegend vorgeschlagene Leuchtstoffmischung ist insbesondere vergleichsweise temperaturstabil. Daher eignet sie sich besonders gut zur Verwendung in einer Straßenlaterne, die als Leuchtmittel zumindest ein Licht emittierendes Halbleiterbauelement gemäß den vorab beschriebenen Ausführungsformen mit zumindest einem Licht emittierender Halbleiterchip und der Leuchtstoffmischung aufweist.

Die beschriebenen Merkmale und Ausführungsformen gelten gleichermaßen für die Leuchtstoffmischung, das Licht emittierende Halbleiterbauelement mit der Leuchtstoffmischung und die Straßenlaterne mit dem Licht emittierenden Halbleiterbauelement.

Die hier beschriebene Leuchtstoffmischung zeigt insbesondere bei der Verwendung in dem Licht emittierenden Halbleiterbauelement einen hohen Farbwiedergabeindex von größer oder gleich 65 und besonders bevorzugt von größer oder gleich 70 über einen sehr großen Farbtemperaturbereich. Der Mindest-Farbwiedergabeindex von 65 und bevorzugt von 70 wird durch die Wahl der beiden Leuchtstoffe auch mit sehr effizienten kurzwelliges Licht emittierenden Halbleiterchips erreicht. Durch die Verwendbarkeit eines großen Wellenlängenbereichs für Licht emittierende Halbleiterchips lässt sich zudem die Produktionsausbeute steigern. Außerdem zeigt die hier beschriebene Leuchtstoffmischung zusätzlich eine gegenüber dem Stand der Technik gesteigerte Konversionseffizienz bei gleichzeitig hoher Beständigkeit gegenüber Strahlung, Temperatur und Feuchtigkeit.

Weitere vorteilhafte Ausführungsformen und Weiterbildungen der Erfindung ergeben sich aus den im Folgenden in Verbindung mit den Figuren beschriebenen Ausführungsbeispielen.
- Figur 1: zeigt eine schematische Darstellung einer Leuchtstoffmischung gemäß einem Ausführungsbeispiel.
- Figur 2: zeigt ein Licht emittierendes Halbleiterbauelement gemäß einem ersten Ausführungsbeispiel.
- Figuren 3 bis 7: zeigen Eigenschaften von Leuchtstoffen und Leuchtstoffmischungen gemäß weiteren Ausführungsbeispielen.
- Figur 8: zeigt eine schematische Darstellung einer Straßenlaterne gemäß einem Ausführungsbeispiel.

Gleiche, gleichartige oder gleich wirkende Elemente sind in den Figuren mit denselben Bezugszeichen versehen. Die Figuren und die Größenverhältnisse der in den Figuren dargestellten Elemente untereinander sind nicht als maßstäblich zu betrachten. Vielmehr können einzelne Elemente, insbesondere Schichtdicken, zur besseren Darstellbarkeit und/oder zum besseren Verständnis übertrieben groß dargestellt sein.

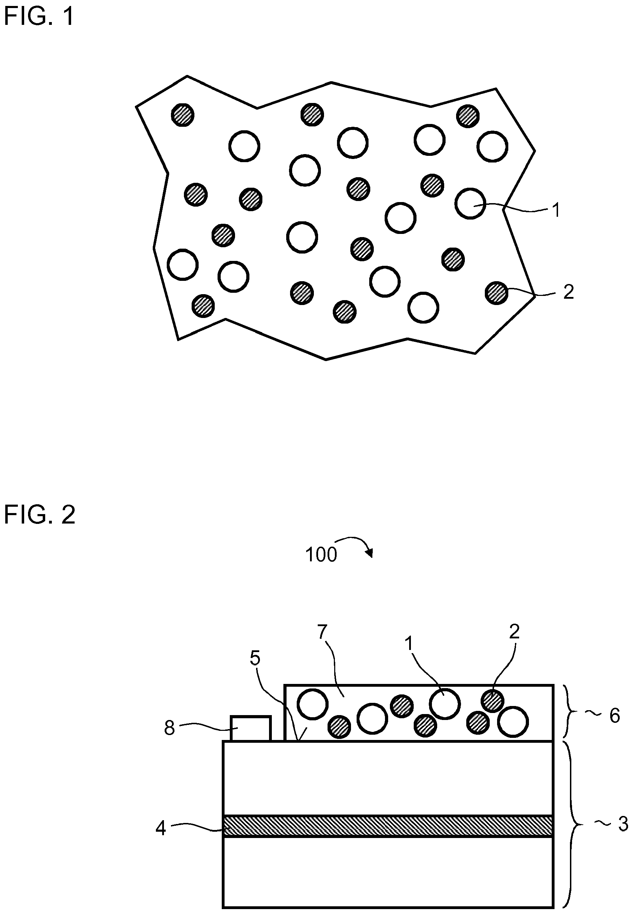

In Figur 1 ist ein Ausführungsbeispiel für eine Leuchtstoffmischung mit einem ersten Leuchtstoff 1 und einem zweiten Leuchtstoff 2 gezeigt, wobei bei Anregung mit Licht in einem ersten Wellenlängenbereich der erste Leuchtstoff 1 Licht in einem zweiten, vom ersten Wellenlängenbereich verschiedenen Wellenlängenbereich und der zweite Leuchtstoff 2 Licht in einem dritten, vom ersten und zweiten Wellenlängenbereich verschiedenen Wellenlängenbereich abstrahlen. Dass der erste, zweite und dritte Wellenlängenbereich voneinander verschieden sind, kann insbesondere bedeuten, dass die Wellenlängenbereiche voneinander verschiedene Intensitätsmaxima aufweisen. Darüber hinaus können die verschiedenen Wellenlängenbereiche aber auch teilweise überlappen. Insbesondere können bei Anregung mit blauem Licht der erste Leuchtstoff 1 grünlich-gelbes Licht und der zweite Leuchtstoff 2 orange-rotes Licht abstrahlen.

Besonders bevorzugt weist das Anregungsspektrum des ersten und/oder des zweiten Leuchtstoffs 1, 2 im blauen Spektralbereich bei einer Wellenlänge von größer oder gleich 440 nm und kleiner oder gleich 460 nm und bevorzugt von größer oder gleich 445 nm und kleiner oder gleich 455 nm ein relatives Maximum auf.

Die Zusammensetzung des ersten Leuchtstoffs 1 ist auf den Wellenlängenbereich des anregenden Lichts und auf das Emissionsspektrum des zweiten Leuchtstoffs 2 so abgestimmt, dass eine hohe Systemeffizienz und Temperaturstabilität des Gesamtsystems erreicht wird. Hierbei wird der erste Leuchtstoff 1 insbesondere so gewählt, dass bei Anregung mit blauem Licht, insbesondere von Licht in einem Wellenlängenbereich von größer oder gleich 440 nm und kleiner oder gleich 460 nm, der Emissionspeak des ersten Leuchtstoffs 1 im Bereich von größer oder gleich 540 nm und kleiner oder gleich 560 nm liegt, während der Emissionspeak des zweiten Leuchtstoffs 2 im Bereich von größer oder gleich 600 und kleiner oder gleich 620 nm und besonders bevorzugt im Bereich von größer oder gleich 605 nm und kleiner oder gleich 615 nm liegt.

Als erster Leuchtstoff 1 ist ein gelblich-grün emittierender Granatleuchtstoff aus dem Materialsystem (Y, Lu, Gd, Ce)₃(Al, Ga)₅O₁₂ vorgesehen. Besonders bevorzugt wird für den ersten Leuchtstoff 1 ein Leuchtstoff aus den Materialsystemen (Y, Lu, Ce)₃Al₅O₁₂ eingesetzt mit einer maximalen Anregbarkeit im Bereich von einschließlich 440 nm bis einschließlich 455 nm, bevorzugt von einschließlich 445 nm bis einschließlich 455 nm. Diese vorab beschriebenen Eigenschaften des ersten Leuchtstoffs 1 werden durch einen Leuchtstoff aus dem Materialsystem (Y, Lu, Ce)₃Al₅O₁₂ mit einem Ce-Gehalt von einschließlich 0,5% bis einschließlich 5% und bevorzugt von einschließlich 1% bis einschließlich 3%, sowie mit einem Y-Gehalt von einschließlich 0 bis einschließlich 20% und bevorzugt von einschließlich 5 bis einschließlich 20%, erreicht. Weiterhin sind auch andere Elementkombinationen möglich, die zu ähnlichen spektralen Eigenschaften führen, insbesondere auch vorgenannte Leuchtstoffe, in denen ein Teil des Al durch Ga substituiert ist.

Der zweite Leuchtstoff 2 ist so ausgewählt, dass sich in Kombination mit dem anregenden Licht und dem Emissionsspektrum des ersten Leuchtstoffs 1 ein Farbwiedergabeindex von größer oder gleich 65 und bevorzugt von größer oder gleich 70 über einem möglichst großen Farbtemperaturbereich ergibt. Der Farbtemperaturbereich erstreckt sich über einschließlich 3000 K bis einschließlich 6500 K. Weiterhin wird die Zusammensetzung des zweiten Leuchtstoffs 2 so ausgewählt, dass eine hohe Stabilität gegenüber Strahlung, Temperatur und Feuchtigkeitseinflüssen erreicht wird.

Der zweite Leuchtstoff 2 weist einen oder mehrere Nitridosilikat-Leuchtstoffe aus den Materialsystemen (Ca, Sr, Ba, Eu)₂Si₅N₈ und (Ca, Sr, Eu)AlSiN₃•Si₂N₂O mit einer Peakwellenlänge der Emission zwischen einschließlich 600 nm und einschließlich 620 nm und besonders bevorzugt zwischen einschließlich 605 nm und einschließlich 615 nm auf.

Man erreicht diese spektralen Eigenschaften mit einem zweiten Leuchtstoff 2 aus dem Materialsystem (Ca, Sr, Ba, Eu)₂Si₅N₈ mit einem Eu-Gehalt von größer oder gleich 1% und kleiner oder gleich 2,5%, mit einem Ba-Gehalt von größer oder gleich 45% und kleiner oder gleich 55% und mit einem Ca-Gehalt von größer oder gleich 0% und kleiner oder gleich 10%. Dabei ist der Sr-Gehalt so gewählt, dass die Summe der Erdalkalimetalle und Europium, also die Summe der Eu-, Ba-, Ca- und Sr-Gehalte, 100% ergibt. Diese für den zweiten Leuchtstoff 2 besonders bevorzugten Leuchtstoffe zeichnen sich neben hoher Konversionseffizienz, Temperaturstabilität der Emission und chemischer Beständigkeit auch durch eine sehr hohe Stabilität gegenüber Strahlung, hohen Temperaturen, Feuchtigkeit und Kombinationen daraus aus.

Alternativ oder zusätzlich kann der zweite Leuchtstoff 2 (Ca, Sr, Eu)AlSiN₃•Si₂N₂O mit einem Eu-Gehalt von größer oder gleich 0,1% und kleiner oder gleich 2% und mit einem Sr-Gehalt von größer oder gleich 60% und kleiner oder gleich 100% aufweisen. Hierbei ist der Ca-Gehalt so gewählt, dass die Summer der Eu-, Sr- und Ca-Gehalte 100% ergibt. Bevorzugt ist der zweite Leuchtstoff 2 so gewählt, dass der Eu-Gehalt größer oder gleich 0,3% und kleiner oder gleich 1% und der Sr-Gehalt größer oder gleich 80% und kleiner oder gleich 100% sind. Da die Wirtsstruktur dieses Materialsystems eine intrinsische Instabilität gegenüber Feuchtigkeit aufweist, ist es vorteilhaft, Partikel dieses Leuchtstoffs mit einer Beschichtung beziehungsweise Umhüllung aus einem inerten Material, beispielsweise SiO₂ und/oder Al₂O₃, zu versehen. Hierdurch kann vermieden werden, dass es beispielsweise unter Bedingungen mit hoher Luftfeuchtigkeit zu einer Degradation der Lumineszenzeigenschaften, beispielsweise in Anwendungen mit Licht emittierenden Dioden, kommt.

Der erste und zweite Leuchtstoff 1, 2 können insbesondere in Form von Partikeln in der Leuchtstoffmischung vorliegen. Im gezeigten Ausführungsbeispiel weist der erste Leuchtstoff 1 zu dem zweiten Leuchtstoff 2, bezogen auf das Gewicht, bevorzugt ein Verhältnis von kleiner oder gleich 100:1 oder kleiner oder gleich 60:1 oder kleiner oder gleich 40:1 und größer oder gleich 2:1 oder größer oder gleich 1:1 oder größer oder gleich 0,5:1 auf.

In Figur 2 ist ein Ausführungsbeispiel für ein Licht emittierendes Halbleiterbauelement 100 mit einem Licht emittierenden Halbleiterchip 3 und ein einer vorab beschriebenen Leuchtstoffmischung auf.

Der Licht emittierende Halbleiterchip 3 ist als Licht emittierende Diode ausgebildet und hat einen aktiven Bereich 4, der dazu geeignet ist, Licht zu erzeugen, das über eine Lichtaustrittsfläche 5 abgestrahlt wird. Der Licht emittierende Halbleiterchip 3 emittiert insbesondere Licht eines ersten Wellenlängenbereichs von seiner Lichtaustrittsfläche 5, wobei der erste Wellenlängenbereich blaue Strahlung, insbesondere mit einer Dominanzwellenlänge von größer oder gleich 440 nm und kleiner oder gleich 460 nm und besonders bevorzugt von größer oder gleich 445 nm und kleiner oder gleich 455 nm umfasst.

Auf die Lichtaustrittsfläche 5 des Licht emittierenden Halbleiterchips 3 weist das Licht emittierende Halbleiterbauelement 100 eine Wellenlängenkonversionsschicht 6 auf. Die Wellenlängenkonversionsschicht 6 weist ein Harz 7 auf, in das eine Leuchtstoffmischung eingebracht ist, wie sie beispielsweise anhand der Figur 1 bereits beschrieben wurde.

Die Partikel des ersten Leuchtstoffs 1 sind dazu geeignet, das blaue Licht des ersten Wellenlängenbereichs, das vorliegend von der Lichtaustrittsfläche 5 des Licht emittierenden Halbleiterchips 3 ausgesandt wird, in gelblich-grünes Licht eines zweiten Wellenlängenbereichs umzuwandeln. Weiterhin wandeln die Partikel des zweiten Leuchtstoffs 2 blaues Licht des ersten Wellenlängenbereichs, das vom aktiven Bereich 4 erzeugt wird, in orange-rotes Licht eines dritten Wellenlängenbereichs um. Die Wellenlängenkonversionsschicht 6 ist dabei derart ausgebildet, dass mischfarbige Strahlung mit einem Farbort im weißen Bereich der CIE-Normfarbtafel entsteht.

Weiterhin ist im gezeigten Ausführungsbeispiel seitlich neben der Wellenlängenkonversionsschicht 6 ein Bondpad 8 aufgebracht, das dazu vorgesehen ist, den Licht emittierenden Halbleiterchip 3 elektrisch zu kontaktieren. Die beschriebene Ausführung des Licht emittierenden Halbleiterchips 3 ist rein beispielhaft zu verstehen. Abweichend vom gezeigten Ausführungsbeispiel kann der Licht emittierende Halbleiterchip 3 auch zusätzliche oder alternative Merkmale von Licht emittierenden Halbleiterchips aufweisen, die dem Fachmann bekannt sind und auf die daher hier nicht weiter eingegangen wird.

Beim hier beschriebenen Licht emittierenden Halbleiterbauelement werden ein spektral optimierter gelblich-grüner erster Leuchtstoff und ein spektral optimierter orange-roter zweiter Leuchtstoff mit einem geeigneten blau-emittierenden Licht emittierenden Halbleiterchip zu einem im Vergleich zum bisherigen Stand der Technik flexibleren Gesamtsystem kombiniert. Die Emission und optimale Anregbarkeit des ersten Leuchtstoffs sind gegenüber üblicherweise gelben Leuchtstoffen bei Lösungen im Stand der Technik zu kürzeren Wellenlängen hin verschoben, wodurch ein höherer Blau-Grün-Anteil im resultierenden Gesamtspektrum erreicht werden kann, um die Farbwiedergabe insbesondere bei hohen Farbtemperaturen und/oder bei der Verwendung kurzwelliger blau emittierender Halbleiterchips zu steigern. Der zweite Leuchtstoff ist so gewählt, dass auch für niedrige Farbtemperaturen ein Mindest-Farbwiedergabeindex von 65 und bevorzugt von 70 gewährleistet werden kann. Das Gesamtsystem ist derart optimiert, dass in einem Farbtemperaturbereich von einschließlich 3000 K bis einschließlich 6500 K auch bei Verwendung kurzwelliger blau emittierender Halbleiterchips , beispielsweise mit einer Dominanzwellenlänge von kleiner oder gleich 446 nm, ein hoher Farbwiedergabeindex von größer oder gleich 65 und bevorzugt von größer oder gleich 70 erreicht wird. Dabei zeigt die hier beschriebene Leuchtstoffmischung trotz ihrer deutlich verbesserten Farbwiedergabe und Flexibilität gleichzeitig auch eine gesteigerte Konversionseffizienz im Vergleich zu Lösungen aus dem Stand der Technik.

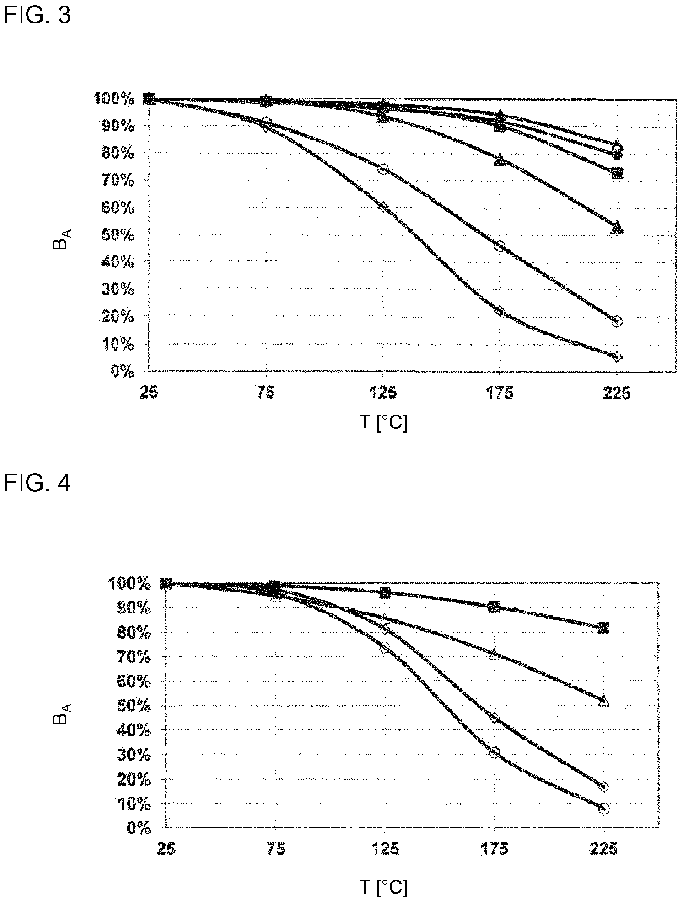

In den Figuren 3 bis 7 sind Eigenschaften von beispielhaften Leuchtstoffen und Leuchtstoffmischungen im Vergleich zu solchen gezeigt, die üblicherweise im Stand der Technik verwendet werden.

In Figur 3 ist die sogenannte Temperatur-Löschung ("thermal quenching") von hier für den zweiten Leuchtstoff beschriebenen Nitridosilikat-Leuchtstoffen im Vergleich zu anderen orange oder rot konvertierenden Leuchtstoffen gezeigt. Hierzu sind auf der horizontalen Achse die Temperatur in °C und auf der vertikalen Achse die absolute Helligkeit B_{A}, relativ zur Helligkeit bei einer Temperatur von 25°C, gezeigt. Als Leuchtstoffe wurden solche mit der Zusammensetzung (Ca, Sr, Ba, Eu)₂Si₅N₈ mit einem Ba-Gehalt von größer oder gleich 45% und kleiner oder gleich 55% und mit einem Ca-Gehalt von größer oder gleich 0% und kleiner oder gleich 10% betrachtet. Insbesondere zeigt die Figur 3 (Sr, Ba)₂Si₅N₈:Eu mit einem Ba-Gehalt von 50% (offene Dreiecke), (Sr, Ba, Ca)₂Si₅N₈:Eu mit einem Ba-Gehalt von 50% und einem Ca-Gehalt von 2,5% (gefüllte Kreise), (Sr, Ba, Ca)₂Si₅N₈:Eu mit einem Ba-Gehalt von 50% und einem Ca-Gehalt von 10% (gefüllte Quadrate), (Sr, Ba)₂Si₅N₈:Eu mit einem Ba-Gehalt von 75% (gefüllte Dreiecke), Ca₂Si₅N₈:Eu (offene Kreise) sowie (Sr, Ba, Ca)₂SiO₄:Eu (offene Rauten). Es zeigt sich, dass insbesondere für einen Ba-Gehalt von 50% und einen Ca-Gehalt von 0% oder 2,5% eine sehr geringe Temperatur-Löschung für den hier beschriebenen zweiten Leuchtstoff erreicht werden kann.

In Figur 4 ist die Temperatur-Löschung von hier für den ersten Leuchtstoff beschriebenen Granat-Leuchtstoffen im Vergleich zu anderen gelb-grünen Leuchtstoffen gezeigt. Die Achsenbeschriftung ist dieselbe wie in Figur 3. Es zeigt sich, dass insbesondere die Zusammensetzung (Y, Lu)₃Al₅O₁₂:Ce mit einem Y-Gehalt von größer oder gleich 0% und kleiner oder gleich 20% (gefüllte Quadrate) zu einer sehr geringen Temperatur-Löschung führt. Die anderen Kurven repräsentieren Y₃(Al, Ga)₅O₁₂:Ce (offene Dreiecke) sowie zwei Zusammensetzungen von (Sr₁₋ₓ, Baₓ)₂SiO₄:Eu (offene Rauten und offene Kreise).

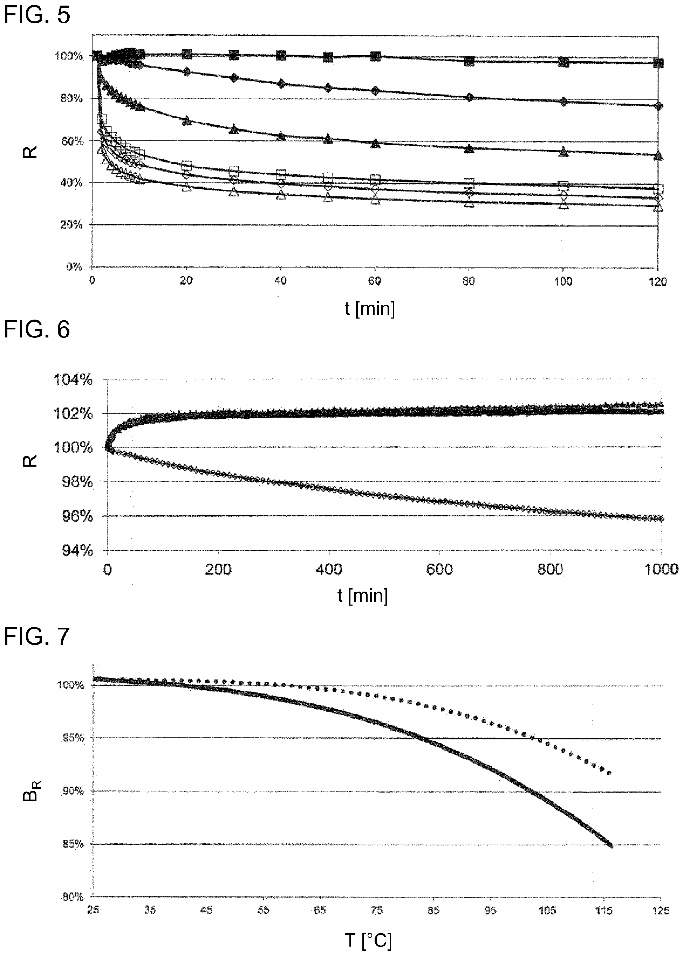

In Figur 5 ist ein Laser-Schnellalterungstest gezeigt, mit dem die Alterungsstabilität des Leuchtstoffsystems (Ca, Sr, Ba)₂Si₅N₈:Eu mit einem Ca-Gehalt von 10% und variablem Ba-Gehalt (gefüllte Quadrate: 50% Ba; gefüllte Rauten: 40% Ba; gefüllte Dreiecke: 30% Ba; offene Quadrate: 20% Ba; offene Rauten: 10% Ba; offene Dreiecke: 0% Ba) ermittelt wurde. Die Proben wurden einer intensiven blauen Laserstrahlung ausgesetzt. Gleichzeitig wurde das Verhältnis aus Rot- und Blaupeak, also das Konversionsverhältnis des resultierenden Spektrums, zeitaufgelöst bestimmt. Figur 5 zeigt die Zeitabhängigkeit des Konversionsgrades R, normiert auf den Wert zum Beginn der Messung, während der Zeit t in Minuten. Je näher der gemessene Wert bei 100% verbleibt, umso stabiler ist der Leuchtstoff. Die Daten zeigen einen starken Einfluss des Ba-Gehalts der Wirtsstruktur auf die Stabilität des Leuchtstoffs. Ab einem Ba-Gehalt von etwa 50% ist im Rahmen der Messfehler keine Degradation mehr messbar, ein Ba-Gehalt von etwa 50% erweist sich somit als besonders vorteilhaft.

In Figur 6 ist ein weiterer Alterungstest zur Bestimmung der Alterungsstabilität des Leuchtstoffsystems (Ca, Sr, Ba)₂Si₅N₈:Eu mit variablem Ba- und Ca-Gehalt (gefüllte Dreiecke: 50% Ba, 2,5% Ca; gefüllte Quadrate: 50% Ba, 0% Ca; offene Rauten: 20% Ba, 0% Ca) gezeigt, wobei im Vergleich zur Messung der Figur 5 als blaue Lichtquelle anstelle eines Lasers als blau emittierende Leuchtdioden ausgeführte Licht emittierende Halbleiterchips mit einer Dominanzwellenlänge von 440 nm verwendet wurden. Die blau emittierenden Halbleiterchips wurden mit einer Silikon-Leuchtstoff-Dispersion vergossen und anschließend bei erhöhter Umgebungstemperatur, insbesondere bei einer am Lötpunkt messbaren Temperatur von 85°C, insgesamt 1000 Minuten bei einem Vorwärtsstrom von 500 mA betrieben. Das Verhältnis aus Rot- und Blaupeak, also das Konversionsverhältnis des resultierenden Spektrums, wurde dabei zeitaufgelöst bestimmt. Die Achsenbeschriftung ist dieselbe wie in Figur 5, aufgetragen ist wiederum die Zeitabhängigkeit des Konversionsgrades R, normiert auf den Wert zum Beginn der Messung. Wie schon die in Figur 5 gezeigte Messung zeigen auch die in Figur 6 gezeigten Daten einen starken Einfluss des Ba-Gehalts der Wirtsstruktur auf die Stabilität des Leuchtstoffs. Bei beiden Proben mit einem Ba-Gehalt von etwa 50% und einem Ca-Gehalt von 0% und 2.5% ist im Rahmen der Messfehler keine Degradation mehr messbar, ein Ba-Gehalt von etwa 50% erweist sich somit als besonders vorteilhaft.

In Figur 7 ist der von der Temperatur T in °C abhängige Verlauf der relativen Helligkeit B_{R} zweier weiß emittierender Halbleiterbauelemente mit einem Farbwiedergabeindex von 70 und einer korrelierten Farbtemperatur von etwa 5000 K gezeigt. Beide Halbleiterbauelemente weisen einen Licht emittierenden Halbleiterchip mit einer Dominanzwellenlänge von 445 nm auf. Die gepunktete Linie zeigt die Messung mit einem hier beschriebenen Halbleiterbauelement mit einer Leuchtstoffmischung mit (Y, Lu)₃Al₅O₁₂:Ce (10% Y, 3% Ce) als erstem Leuchtstoff und mit (Ca, Sr, Ba)₂Si₅N₈:Eu (2,5% Ca, 50% Ba, 2% Eu) als zweitem Leuchtstoff. Die durchgezogene Linie zeigt die Messung mit einer Leuchtdiode aus dem Stand der Technik mit einer Kombination aus Y₃(Al, Ga)₅O₁₂:Ce (25% Ga, 4% Ce) und (Sr, Ba)₂Si₅N₈:Eu (50% Ba, 4% Eu). Während die Leuchtdiode gemäß dem Stand der Technik bei einer Temperatur T von 116°C etwa 16% Helligkeit gegenüber dem Betrieb bei Raumtemperatur verliert, reduziert sich die Helligkeit bei dem Halbleiterbauelement mit der hier beschriebenen Leuchtstoffmischung nur um etwa 9%.

Zusätzlich zu den beschriebenen Messungen wurden weitere Versuche durchgeführt, bei denen hier beschriebene Leuchtstoffmischungen mit Leuchtstoffkombinationen aus dem Stand der Technik verglichen wurden.

Als besonders vorteilhaft haben sich hierbei zusätzlich zu den vorab und im Zusammenhang mit den Ausführungsbeispielen und im allgemeinen Teil beschriebenen Leuchtstoffmischungen in Kombination mit blau emittierenden Halbleiterchips insbesondere die folgenden Leuchtstoffmischungen erwiesen, wobei außerdem jeweils die Dominanzwellenlänge des ersten Leuchtstoffs, die Gesamtkonzentration, das Grün-Rot-Verhältnis, die Farbortkoordinaten cx und cy, die korrelierte Farbtemperatur CCT in K und der Farbwiedergabeindex CRI angegeben sind:
1. (Vergleichsbeispiel) Dominanzwellenlänge des
   Halbleiterchips: 450 nm;
   erster Leuchtstoff: (Y, Lu)₃Al₅O₁₂: Ce (5% Y, 3% Ce) ;
   zweiter Leuchtstoff: (Sr, Ba)₂Si₅N₈:Eu (50% Ba, 4% Eu) ;
   Dominanzwellenlänge des ersten Leuchtstoffs: 566,6 nm;
   Gesamtkonzentration: 17,1%;
   Grün-Rot-Verhältnis: 30,0:1;
   cx: 0,338; cy: 0,370;
   CCT: 5310 K;
   CRI: 70
2. Dominanzwellenlänge des Halbleiterchips: 444,5 nm; erster Leuchtstoff: (Y, Lu)₃Al₅O₁₂:Ce (15% Y, 2% Ce) ; zweiter Leuchtstoff: (Ca, Sr, Ba)₂Si₅N₈:Eu (50% Ba, 0% Ca, 1% Eu);
   Dominanzwellenlänge des ersten Leuchtstoffs: 565,2 nm; Gesamtkonzentration: 20,3%;
   Grün-Rot-Verhältnis: 3,2:1;
   cx: 0,433; cy: 0,406;
   CCT: 3075 K;
   CRI: 68
3. Dominanzwellenlänge des Halbleiterchips: 444,4 nm; erster Leuchtstoff: (Y, Lu)₃Al₅O₁₂:Ce (15% Y, 2% Ce) ; zweiter Leuchtstoff: (Ca, Sr, Ba)₂Si₅N₈:Eu (50% Ba, 2,5% Ca, 1% Eu);
   Dominanzwellenlänge des ersten Leuchtstoffs: 565,2 nm;
   Gesamtkonzentration: 19,5%;
   Grün-Rot-Verhältnis: 3,25:1;
   cx: 0,432; cy: 0,404;
   CCT: 3079 K;
   CRI: 69
4. Dominanzwellenlänge des Halbleiterchips: 444,5 nm;
   erster Leuchtstoff: (Y, Lu)₃Al₅O₁₂:Ce (15% Y, 2% Ce) ; zweiter Leuchtstoff: (Ca, Sr, Ba)₂Si₅N₈:Eu (50% Ba, 0% Ca, 1,5% Eu) ;
   Dominanzwellenlänge des ersten Leuchtstoffs: 565,2 nm;
   Gesamtkonzentration: 18,5%;
   Grün-Rot-Verhältnis: 4,5:1;
   cx: 0,432; cy: 0,403;
   CCT: 3072 K;
   CRI: 70
5. Dominanzwellenlänge des Halbleiterchips: 444,5 nm;
   erster Leuchtstoff: (Y, Lu)₃Al₅O₁₂:Ce (15% Y, 2% Ce) ;
   zweiter Leuchtstoff: (Ca, Sr, Ba)₂Si₅N₈:Eu (50% Ba, 0% Ca,
   1% Eu);
   Dominanzwellenlänge des ersten Leuchtstoffs: 565,2 nm;
   Gesamtkonzentration: 16,5%;
   Grün-Rot-Verhältnis: 8,3:1;
   cx: 0,345; cy: 0,354;
   CCT: 5029 K;
   CRI: 70
6. Dominanzwellenlänge des Halbleiterchips: 444,4 nm;
   erster Leuchtstoff: (Y, Lu)₃Al₅O₁₂:Ce (15% Y, 2% Ce) ;
   zweiter Leuchtstoff: (Ca, Sr, Ba)₂Si₅N₈:Eu (50% Ba, 0% Ca, 1% Eu);
   Dominanzwellenlänge des ersten Leuchtstoffs: 565,2 nm;
   Gesamtkonzentration: 13,7%;
   Grün-Rot-Verhältnis: 14,0:1;
   cx: 0,314; cy: 0,329;
   CCT: 6450 K;
   CRI: 69

Bei Leuchtstoffkombinationen aus dem Stand der Technik wurde festgestellt, dass bei einer Variation des ersten Leuchtstoffs derart, dass dessen Emission zunehmend kurzwellig verschoben wird, der Farbwiedergabeindex stetig zunimmt und die relative Effizienz und das Grün-Rot-Verhältnis stetig abnehmen.

Das vorab beschriebene Vergleichsbeispiel 1 für eine Leuchtstoffmischung zur Erzeugung von Mischlicht mit einem Farbwiedergabeindex von etwa 70 und einer korrelierten Farbtemperatur im Bereich von etwa 5000 K zeigt jedoch auch bei einer Verschiebung der Emission des ersten Leuchtstoffs zu kürzeren Wellenlängen hin eine größere relative Effizienz als die Referenzleuchtstoffkombination aus dem Stand der Technik. Derselbe Effekt lässt sich auch bei den Beispielen 2 bis 4 für Leuchtstoffmischungen feststellen, die zur Erzeugung von Mischlicht mit einem Farbwiedergabeindex von etwa 70 und einer korrelierten Farbtemperatur im Bereich von etwa 3000 K vorgesehen sind, sowie beim Beispiel 5, dessen Leuchtstoffmischung zur Erzeugung von Mischlicht mit einem Farbwiedergabeindex von etwa 70 und einer korrelierten Farbtemperatur im Bereich von etwa 5000 K vorgesehen ist, und beim Beispiel 6, dessen Leuchtstoffmischung zur Erzeugung von Mischlicht mit einem Farbwiedergabeindex von etwa 70 und einer korrelierten Farbtemperatur im Bereich von etwa 6500 K vorgesehen ist. Insbesondere konnte somit unter anderem festgestellt werden, dass die vorab genannten Leuchtstoffmischungen eine signifikant erhöhte relative Effizienz im Vergleich zu einer jeweiligen Referenzleuchtstoffmischung aus dem Stand der Technik zeigen.

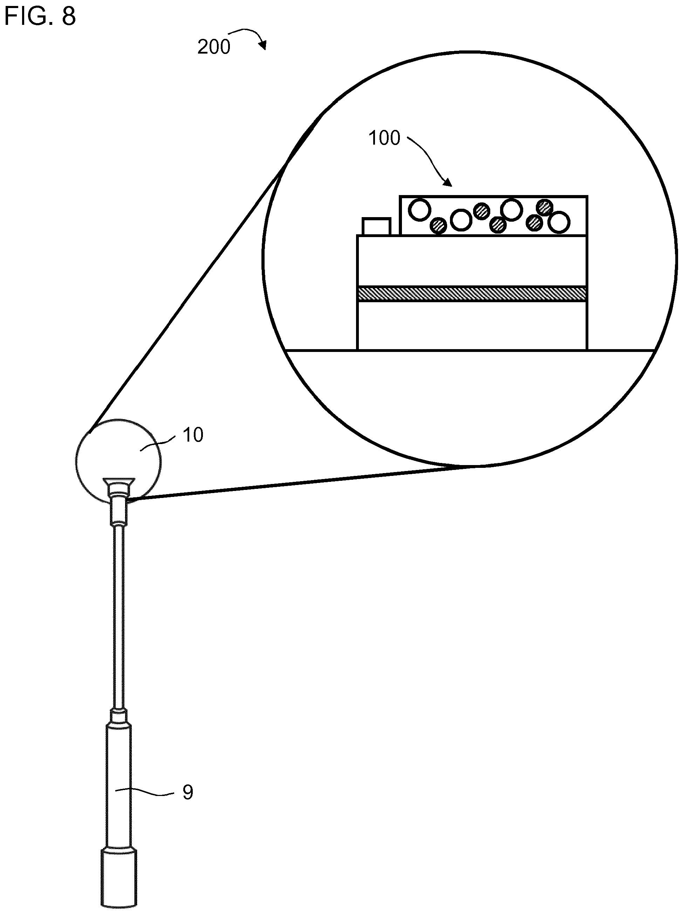

In Figur 8 ist ein Ausführungsbeispiel für eine Straßenlaterne 200 gezeigt. Die Straßenlaterne 200 weist einen Lampenfuß 9 sowie einen Lampenschirm 10 auf, der das Leuchtmittel umgibt. Als Leuchtmittel wird ein Licht emittierendes Halbleiterbauelement 100 verwendet, wie es beispielsweise oben im Zusammenhang mit der Figur 2 beschrieben wird.

Die im Zusammenhang mit den Figuren beschriebenen Ausführungsbeispiele und Merkmale können miteinander kombiniert werden. Weiterhin können die in den Figuren gezeigten Ausführungsbeispiele alternativ oder zusätzlich weitere Merkmale und Ausführungsformen gemäß der Beschreibung im allgemeinen Teil aufweisen.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Leuchtstoffmischung mit einem ersten Leuchtstoff (1) und einem zweiten Leuchtstoff (2),
wobei bei Anregung mit blauem Licht das Emissionsspektrum des ersten Leuchtstoffs (1) ein relatives Intensitätsmaximum im gelblich-grünen Spektralbereich bei einer Wellenlänge von größer oder gleich 540 nm und kleiner oder gleich 560 nm aufweist und das Emissionsspektrum des zweiten Leuchtstoffs (2) ein relatives Intensitätsmaximum im orange-roten Spektralbereich bei einer Wellenlänge von größer oder gleich 600 nm und kleiner oder gleich 620 nm aufweist, wob
ei der zweite Leuchtstoff (2) ausgewählt ist aus dem Materialsystem (Ca, Sr, Eu)AlSiN₃•Si₂N₂O und aus dem Materialsystem (Ca, Sr, Ba, Eu)2Si₅N₈ mit einem Eu-Gehalt von größer oder gleich 1 Mol-% und kleiner oder gleich 2,5 Mol-%, mit einem Ba-Gehalt von größer oder gleich 45 Mol-% und kleiner oder gleich 55 Mol-% und mit einem Ca-Gehalt von größer oder gleich 0 Mol-% und kleiner oder gleich 10 Mol-%, wobei der Sr-Gehalt so gewählt ist, dass die Summe der Eu-, Ba-, Ca- und Sr-Gehalte 100 Mol-% ergibt,
wobei der erste Leuchtstoff (1) ausgewählt ist aus dem Materialsystem (Y, Lu, Ce)₃Al₅O₁₂ mit einem Ce-Gehalt von größer oder gleich 0,5 Mol-% und kleiner oder gleich 5 Mol-% und einem Y-Gehalt von größer oder gleich 0 Mol-% und kleiner oder gleich 20 Mol-%, und wob
ei das von der Leuchtstoffmischung bei Anregung mit blauem Licht erzeugte Licht einen Farbort mit einer Farbtemperatur zwischen einschließlich 3000 K und einschließlich 6500 K und einen Farbwiedergabeindex von mindestens 65 aufweist.

2. Leuchtstoffmischung nach dem vorherigen Anspruch, wobei der erste Leuchtstoff (1) ein Granatleuchtstoff ist.

3. Leuchtstoffmischung nach dem vorherigen Anspruch, wobei der erste Leuchtstoff (1) ein relatives Intensitätsmaximum bei einer Wellenlänge von größer oder gleich 545 nm und kleiner oder gleich 555 nm aufweist.

4. Leuchtstoffmischung nach einem der vorherigen Ansprüche, wobei der erste Leuchtstoff (1) eine maximale Anregbarkeit bei einer Wellenlänge von größer oder gleich 440 nm und kleiner oder gleich 460 nm, bevorzugt von größer oder gleich 445 nm und kleiner oder gleich 455 nm, aufweist.

5. Leuchtstoffmischung nach einem der vorherigen Ansprüche, wobei der Ce-Gehalt größer oder gleich 1 Mol-% und kleiner oder gleich 3 Mol-% und der Y-Gehalt größer oder gleich 5 Mol-% und kleiner oder gleich 20 Mol-% sind.

6. Leuchtstoffmischung nach einem der vorherigen Ansprüche, wobei der zweite Leuchtstoff (2) ein relatives Intensitätsmaximum bei einer Wellenlänge von größer oder gleich 605 nm und kleiner oder gleich 615 nm aufweist.

7. Leuchtstoffmischung nach einem der vorherigen Ansprüche, wobei der zweite Leuchtstoff (2) ausgewählt ist aus dem Materialsystem (Ca, Sr, Eu)AlSiN₃•Si₂N₂O mit einem Eu-Gehalt von größer oder gleich 0,1 Mol-% und kleiner oder gleich 2 Mol-% und mit einem Sr-Gehalt von größer oder gleich 60 Mol-% und kleiner 100 Mol-%, wobei der Ca-Gehalt so gewählt ist, dass die Summer der Eu-, Sr- und Ca-Gehalte 100 Mol-% ergibt.

8. Leuchtstoffmischung nach einem der vorherigen Ansprüche, wobei der erste und zweite Leuchtstoff (1, 2) in Form von Partikeln vorliegen.

9. Leuchtstoffmischung nach einem der vorherigen Ansprüche, wobei der zweite Leuchtstoff (2) ausgewählt ist aus dem Materialsystem (Ca, Sr, Eu)AlSiN₃•Si₂N₂O und als Partikel mit einer inerten Beschichtung ausgewählt aus SiO₂ und Al₂O₃ ausgebildet ist.

10. Licht emittierendes Halbleiterbauelement mit einem Licht emittierenden Halbleiterchip (3), der im Betrieb Licht in einem ersten Wellenlängenbereich aussendet und einer Leuchtstoffmischung nach einer der vorherigen Ansprüche, die zumindest einen Teil des von dem Licht emittierenden Halbleiterchip (3) ausgesandten Lichts im ersten Wellenlängenbereich in Licht in einem vom ersten verschiedenen zweiten Wellenlängenbereich und in Licht in einem vom ersten und zweiten verschiedenen dritten Wellenlängenbereich umwandelt.

11. Licht emittierendes Halbleiterbauelement nach dem vorherigen Anspruch, wobei der erste Wellenlängenbereich eine Dominanzwellenlänge von größer oder gleich 440 nm und kleiner oder gleich 460 nm und bevorzugt von größer oder gleich 445 nm und kleiner oder gleich 455 nm aufweist.

12. Licht emittierendes Halbleiterbauelement nach Anspruch 11, das weißes Licht aussendet, das sich aus Licht des ersten Wellenlängenbereichs und Licht des zweiten und dritten Wellenlängenbereichs zusammensetzt und einen Farbwiedergabeindex von größer oder gleich 70 bei einer Farbtemperatur von größer oder gleich 3000 K und kleiner oder gleich 6500 K aufweist.

13. Straßenlaterne mit einem Licht emittierender Halbleiterbauelement nach einem der Ansprüche 10 bis 12.

## Claims

1. A luminescent-substance mixture comprising a first luminescent substance (1) and a second luminescent substance (2),
wherein, upon excitation with blue light, the emission spectrum of the first luminescent substance (1) comprises a relative intensity maximum in the yellowish-green spectral range at a wavelength of greater than or equal to 540 nm and less than or equal to 560 nm and the emission spectrum of the second luminescent substance (2) comprises a relative intensity maximum in the orange-red spectral range at a wavelength of greater than or equal to 600 nm and less than or equal to 620 nm,
wherein the second luminescent substance (2) is selected from the material system (Ca, Sr, Eu)AlSiN₃•Si₂N₂O and from the material system (Ca, Sr, Ba, Eu)₂Si₅N₈ with an Eu content greater than or equal to 1 mol% and less than or equal to 2.5 mol%, with a Ba content of greater than or equal to 45 mol% and less than or equal to 55 mol% and with a Ca content of greater than or equal to 0 mol% and less than or equal to 10 mol%, wherein the Sr content is selected such that the sum of the Eu, Ba, Ca and Sr contents is 100 mol%,
wherein the first luminescent substance (1) is selected from the material system (Y, Lu, Ce)₃Al₅O₁₂ with a Ce content of greater than or equal to 0.5 mol% and less than or equal to 5 mol% and a Y content of greater than or equal to 0 mol% and less than or equal to 20 mol%, and whe
rein the light produced by the luminescent-substance mixture upon excitation with blue light comprises a color locus having a color temperature between 3000 K, inclusive, and 6500 K, inclusive, and a color rendering index of at least 65.

2. The luminescent-substance mixture according to the preceding claim, wherein the first luminescent substance (1) is a garnet luminescent substance.

3. The luminescent-substance mixture according to the preceding claim, wherein the first luminescent substance (1) comprises a relative intensity maximum at a wavelength greater than or equal to 545 nm and less than or equal to 555 nm.

4. The luminescent-substance mixture according to one of the preceding claims, wherein the first luminescent substance (1) comprises a maximum excitability at a wavelength greater than or equal to 440 nm and less than or equal to 460 nm, preferably greater than or equal to 445 nm and less than or equal to 455 nm.

5. The luminescent-substance mixture according to one of the preceding claims, wherein the Ce content is greater than or equal to 1 mol% and less than or equal to 3 mol% and the Y content is greater than or equal to 5 mol% and less than or equal to 20 mol%.

6. The luminescent-substance mixture according to one of the preceding claims, wherein the second luminescent substance (2) comprises a relative intensity maximum at a wavelength greater than or equal to 605 nm and less than or equal to 615 nm.

7. The luminescent-substance mixture according to one of the preceding claims, wherein the second luminescent substance (2) is selected from the material system (Ca, Sr, Eu)AlSiN₃•Si₂N₂O with an Eu content of greater than or equal to 0.1 mol% and less than or equal to 2 mol% and with an Sr content of greater than or equal to 60 mol% and less than 100 mol%, wherein the Ca content is selected such that the sum of the Eu, Sr and Ca contents is 100 mol%.

8. The luminescent-substance mixture according to one of the preceding claims, wherein the first and second luminescent substances (1, 2) are present in the form of particles.

9. The luminescent-substance mixture according to one of the preceding claims, wherein the second luminescent substance (2) is selected from the material system (Ca, Sr, Eu)AlSiN₃•Si₂N₂O and is formed as a particle with an inert coating selected from SiO₂ and Al₂O₃.

10. A light-emitting semiconductor component comprising a light-emitting semiconductor chip (3) which, during operation, emits light in a first wavelength range, and a luminescent-substance mixture according to one of the preceding claims which converts at least part of the light emitted by the light-emitting semiconductor chip (3) in the first wavelength range into light in a second wavelength range different from the first wavelength range and into light in a third wavelength range different from the first and second wavelength range.

11. The light-emitting semiconductor component according to the preceding claim, wherein the first wavelength range comprises a dominant wavelength of greater than or equal to 440 nm and less than or equal to 460 nm and preferably greater than or equal to 445 nm and less than or equal to 455 nm.

12. The light-emitting semiconductor component according to claim 11, which emits white light which is composed of light of the first wavelength range and light of the second and third wavelength ranges and which comprises a color rendering index greater than or equal to 70 at a color temperature greater than or equal to 3000 K and less than or equal to 6500 K.

13. A streetlamp comprising a light-emitting semiconductor component according to one of the claims 10 to 12.

## Revendications

1. Mélange de matières luminescentes comprenant une première matière luminescente (1) et une seconde matière luminescente (2),
sachant qu'en cas d'excitation avec de la lumière bleue, le spectre d'émission de la première matière luminescente (1) présente un maximum d'intensité relative dans la zone spectrale jaune-vert à une longueur d'onde supérieure ou égale à 540 nm et inférieure ou égale à 560 nm et le spectre d'émission de la seconde matière luminescente (2) présente un maximum d'intensité relative dans la zone spectrale orange-rouge à une longueur d'onde supérieure ou égale à 600 nm et inférieure ou égale à 620 nm,
sachant que la seconde matière luminescente (2) est sélectionnée à partir du système de matières (Ca, Sr, Eu)AlSiN₃•Si₂N₂O et du système de matières (Ca, Sr, Ba, Eu)₂Si₅N₈ avec une teneur en Eu supérieure ou égale à 1 % en moles et inférieure ou égale à 2,5 % en moles, avec une teneur en Ba supérieure ou égale à 45 % en moles et inférieure ou égale à 55 % en moles et avec une teneur en Ca supérieure ou égale à 0 % en moles et inférieure ou égale à 10 % en moles, sachant que la teneur en Sr est sélectionnée de sorte que la somme des teneurs en Eu, en Ba, en Ca et en Sr donne 100 % en moles,
sachant que la première matière luminescente (1) est sélectionnée à partir du système de matières (Y, Lu, Ce)₃Al₅O₁₂ avec une teneur en Ce supérieure ou égale à 0,5 % en moles et inférieure ou égale à 5 % en moles et une teneur en Y supérieure ou égale à 0 % en moles et inférieure ou égale à 20 % en moles, et
sachant que la lumière produite par le mélange de matières luminescentes en cas d'excitation avec de la lumière bleue présente une localisation chromatique avec une température de couleur comprise entre 3000 K et 6500 K inclus et un indice de rendu des couleurs d'au moins 65.

2. Mélange de matières luminescentes selon la revendication précédente, sachant que la première matière luminescente (1) est une matière luminescente de grenat.

3. Mélange de matières luminescentes selon la revendication précédente, sachant que la première matière luminescente (1) présente un maximum d'intensité relative à une longueur d'onde supérieure ou égale à 545 nm et inférieure ou égale à 555 nm.

4. Mélange de matières luminescentes selon une quelconque des revendications précédentes, sachant que la première matière luminescente (1) présente une excitabilité maximale à une longueur d'onde supérieure ou égale à 440 nm et inférieure ou égale à 460 nm, de préférence supérieure ou égale à 445 nm et inférieure ou égale à 455 nm.

5. Mélange de matières luminescentes selon une quelconque des revendications précédentes, sachant que la teneur en Ce est supérieure ou égale à 1 % en moles et inférieure ou égale à 3 % en moles et que la teneur en Y est supérieure ou égale à 5 % en moles et inférieure ou égale à 20 % en moles.

6. Mélange de matières luminescentes selon une quelconque des revendications précédentes, sachant que la seconde matière luminescente (2) présente un maximum d'intensité relative à une longueur d'onde supérieure ou égale à 605 nm et inférieure ou égale à 615 nm.

7. Mélange de matières luminescentes selon une quelconque des revendications précédentes, sachant que la seconde matière luminescente (2) est sélectionnée à partir du système de matières (Ca, Sr, Eu)AlSiN₃•Si₂N₂O avec une teneur en Eu supérieure ou égale à 0,1 % en moles et inférieure ou égale à 2 % en moles et avec une teneur en Sr supérieure ou égale à 60 % en moles et inférieure ou égale à 100 % en moles, sachant que la teneur en Ca est sélectionnée de sorte que la somme des teneurs en Eu, en Sr et en Ca donne 100 % en moles.

8. Mélange de matières luminescentes selon une quelconque des revendications précédentes, sachant que la première ou la seconde matière luminescente (1, 2) sont présentes sous forme de particules.

9. Mélange de matières luminescentes selon une quelconque des revendications précédentes, sachant que la seconde matière luminescente (2) est sélectionnée à partir du système de matières (Ca, Sr, Eu)AlSiN₃•Si₂N₂O et constituée comme particule avec un revêtement inerte sélectionné à partir du SiO₂ et de l'Al₂O₃.

10. Élément semiconducteur émetteur de lumière avec une puce semiconductrice émettrice de lumière (3) qui, en fonctionnement, émet de la lumière dans un premier domaine spectral, et avec un mélange de matières luminescentes selon une quelconque des revendications précédentes qui convertit au moins une partie de la lumière émise par la puce semiconductrice émettrice de lumière (3) dans le premier domaine spectral en lumière dans un second domaine spectral différent du premier et en lumière dans un troisième domaine spectral différent du premier et du second.

11. Élément semiconducteur émetteur de lumière selon la revendication précédente, sachant que le premier domaine spectral présente une longueur d'onde de dominance supérieure ou égale à 440 nm et inférieure ou égale à 460 nm, et de préférence supérieure ou égale à 445 nm et inférieure ou égale à 455 nm.

12. Élément semiconducteur émetteur de lumière selon la revendication 11, qui émet de la lumière blanche, qui se compose de lumière du premier domaine spectral et de lumière des second et troisième domaines spectraux et présente un indice de rendu des couleurs supérieur ou égal à 70 à une température de couleur supérieure ou égale à 3000 K et inférieure ou égale à 6500 K.

13. Lampadaire avec un élément semiconducteur émetteur de lumière selon une quelconque des revendications 10 à 12.
